**Europäisches Patentamt**

**European Patent Office**

**Office européen des brevets**

(19)

(11) Numéro de publication: **0 045 674**
**B1**

(12) **FASCICULE DE BREVET EUROPEEN**

(45) Date de publication du fascicule du brevet:
**11.07.84**

(21) Numéro de dépôt: **81401154.0**

(22) Date de dépôt: **21.07.81**

(51) Int. Cl.³: **H 01 L 21/306**, C 23 F 1/00,
C 23 C 15/00

(54) Procédé et dispositif d'attaque sous plasma d'une couche mince.

(30) Priorité: **24.07.80 FR 8016329**

(43) Date de publication de la demande:
**10.02.82 Bulletin 82/6**

(45) Mention de la délivrance du brevet:
**11.07.84 Bulletin 84/28**

(84) Etats contractants désignés:
**CH DE FR GB IT LI NL**

(56) Documents cités:
**EP - A - 0 013 483**
**FR - A - 2 364 593**
**US - A - 4 198 261**
**US - A - 4 208 240**

(73) Titulaire: **SOCIETE POUR L'ETUDE ET LA FABRICATION**
**DE CIRCUITS INTEGRES SPECIAUX - E.F.C.I.S.,**
**17, avenue des Martyrs, F-38100 Grenoble (FR)**

(72) Inventeur: **Montier, Michel, 173, bld Haussmann,**
**F-75360 Paris Cedex 08 (FR)**

(74) Mandataire: **de Beaumont, Michel, THOMSON-CSF**
**SCPI 173, Bld Haussmann, F-75379 Paris Cedex 08 (FR)**

## Description

La présente invention concerne un procédé et un dispositif d'attaque sous plasma d'une couche mince, et plus particulièrement un procédé et un dispositif de détection de la fin d'une telle attaque.

La présente invention s'applique plus particulièrement à la fabrication de dispositifs semi-conducteurs, discrets ou intégrés, dans lesquels on dépose ou l'on fait croître successivement sur un substrat des couches minces multiples qui sont gravées selon des configurations souhaitées. Cette gravure d'une couche mince reposant sur un substrat massif (ou sur une autre couche) est généralement effectuée à travers un masque de configuration désirée par attaque chimique ou sous plasma.

Dans le cas de l'utilisation d'une attaque sous plasma, on s'intéressera ici plus particulièrement au problème de la détection de fin d'attaque. En effet, il est important de savoir arrêter la gravure à l'interface entre la couche mince et le substrat avec précision, ce qui est, dans la pratique, rendu difficile du fait que:

— la gravure n'est pas parfaitement homogène sur un échantillon donné et entre plusieurs échantillons, c'est-à-dire que certaines régions sont mises à nu avant d'autres et que l'on atteint l'interface entre la couche mince et la couche sous-jacente progressivement d'une région à l'autre;

— la sélectivité d'attaque entre la vitesse d'attaque de la couche mince que l'on souhaite graver et de la couche (ou substrat) sous-jacente est assez faible; de façon générale, le rapport entre ces vitesses varie entre 1 et 10 selon les cas.

Ainsi, si la gravure est trop courte, on risque de maintenir des parties de la couche mince indésirées mais, si la gravure est trop longue, on risque d'une part d'attaquer la couche sous-jacente, d'autre part de créer des surgravures de valeurs mal déterminées sous les couches de masquage.

Pour tenter de résoudre ce problème de la détermination de la fin d'attaque d'une couche mince, on a proposé dans l'art antérieur plusieurs procédés.

L'un d'eux consiste à effectuer une mesure par spectrophotométrie: on détecte par ce procédé l'apparition ou la disparition d'une raie optique caractéristique du spectre de décharge du plasma en cours d'attaque d'une couche de nature donnée. Néanmoins, ce procédé est lourd à mettre en œuvre et présente un temps de réponse non négligeable ne permettant pas de faire une sélection précise de la fin d'attaque.

Un autre consiste à faire des mesures par spectrométrie de masse: on détecte par ce procédé des ions ou molécules caractéristiques du plasma en cours d'attaque. Ce procédé est également lourd à mettre en œuvre et présente un temps de réponse long.

Un autre procédé encore consiste à procéder par réflectométrie ou ellipsométrie optique: ce procédé consiste à diriger un pinceau lumineux vers la couche mince en cours d'attaque et à mesurer sa variation d'épaisseur au cours du temps. Ce procédé ponctuel est d'une part relativement délicat à mettre en œuvre; d'autre part, il ne permet pas de tenir compte de l'inhomogénéité de la gravure et suppose que les substrats sont fixes.

Ainsi, un objet de la présente invention est de prévoir un nouveau procédé et dispositif de fin d'attaque sous plasma d'une couche mince, ce procédé permettant une détection rapide de fin d'attaque, étant simple à mettre en œuvre et étant peu coûteux.

Pour atteindre ces objets, la présente invention prévoit un procédé d'attaque complète sous plasma d'une couche mince déposée sur un substrat de nature physique ou chimique distincte, comprenant les étapes consistant à mesurer la pression dans l'enceinte dans laquelle se produit l'attaque et à arrêter cette attaque après que la pression dans l'enceinte a atteint un palier, puis s'est écartée de la valeur de ce palier.

Un dispositif selon la présente invention, mettant en œuvre ce procédé, comprend un capteur de pression dans l'enceinte dans laquelle se produit l'attaque, des moyens de détection des variations de cette pression, des moyens pour fournir un signal de commande propre à provoquer l'arrêt de l'opération d'attaque une fois que la pression a atteint un palier et peu après qu'elle s'est écartée de ce palier.

On notera qu'un détecteur de pression constitue un capteur particulièrement simple à côté des capteurs du type de ceux utilisés dans l'art antérieur tels que les spectrophotomètres, des spectromètres, ou des ensembles de réflectométrie optique.

Ces objets, caractéristiques et avantages de la présente invention seront exposés plus en détail dans la description suivante de modes de réalisation particuliers faite en relation avec les figures jointes parmi lesquelles:

la fig. 1 représente une structure formée par attaque sous plasma,

la fig. 2 représente des variations de pression dans une enceinte d'attaque sous plasma.

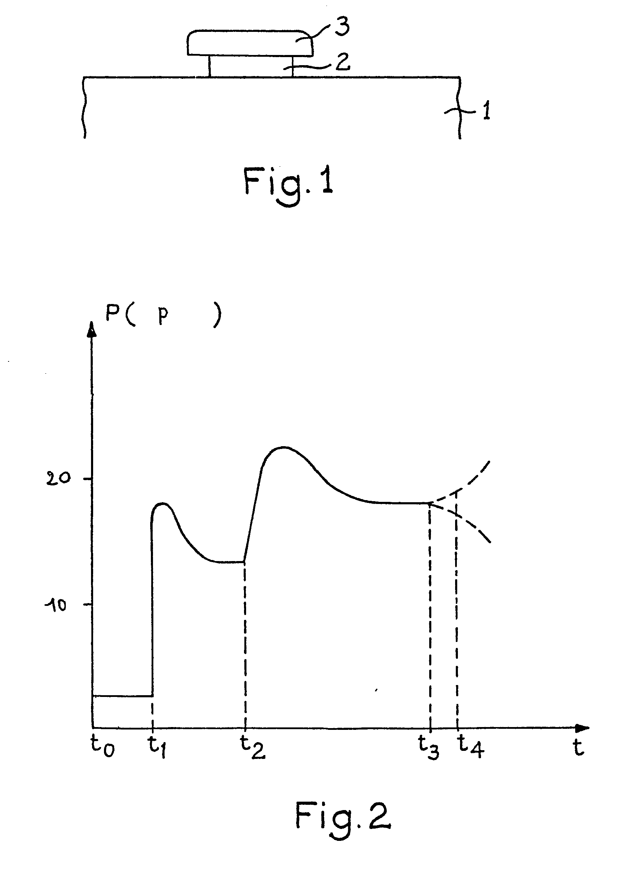

La fig. 1 représente un substrat 1 sur lequel a été formée une zone d'une couche mince 2 sous une couche de masquage 3. Le substrat 1 est par exemple un substrat de silicium revêtu d'une couche de silice (non représentée); la couche mince 2 est par exemple une couche de silicium polycristallin, et le masque 3 est par exemple un masque de résine.

Par les procédés classiques d'attaque sous plasma, la fin d'attaque n'est pas spécifiquement détectée et l'attaque est prolongée pendant une durée moyenne résultant de l'expérience acquise. Il en résulte des dispersions d'attaque résultant de légères variations des conditions d'attaque ou de nature des couches. Parmi les inconvénients de ce procédé, on peut citer notamment que la zone de surgravure latérale de la couche 2 sous le masque 3 est très variable: par exemple, dans la pratique, on trouve une dispersion de l'ordre de 0,5 à 1,5 fois l'épaisseur de la couche gravée. Une telle dispersion est très importante en valeur relative alors que la dimenson du motif élémentaire de la couche 2 que l'on veut maintenir peut être de l'ordre du micron.

La présente invention résulte d'une analyse détaillée du processus de variation de pression dans l'enceinte d'attaque sous plasma au cours d'une attaque.

La fig. 2 illustre à titre d'exemple l'allure des variations de pression. Des pressions ont été indiquées en ordonnées, en pascals, mais sont purement indicatives et dépendront en pratique des conditions particulières choisies pour l'attaque, de la couche à attaquer et du gaz présent dans l'enceinte. Dans une première étape, ente les instants $t_0$ et $t_1$, l'enceinte est vidée. Ensuite, dans une deuxième étape, entre les instants $t_1$ et $t_2$, le gaz d'attaque, par exemple un mélange de $SF_6$ et de $O_2$ ou du $CF_4$, est introduit dans l'enceinte. A l'instant $t_2$, les perturbations de pression résultant de l'introduction du gaz sont stabilisées et la pression a atteint un palier. Ensuite, une décharge est produite dans le gaz et la gravure prend place entre les instants $t_2$ et $t_3$. Dans une première étape, la pression monte relativement rapidement puis diminue pour atteindre un palier.

La constatation expérimentale sur laquelle se base la présente invention résulte de la constatation du fait que, une fois que la couche mince à attaquer (la couche 2 dans le cas de la fig. 1) est éliminée et que l'attaque commence à affecter le subtrat sous-jacent, il se produit une variation de la pression dans l'enceinte. Cette variation peut aller dans le sens d'une augmentation ou d'une diminution de pression. Par exemple, une augmentation de pression se produira dans le cas d'une couche de silicium polycristallin sur de la silice, et une diminution de pression dans le cas d'une couche de silicium polycristallin sur du corindon.

L'instant $t_3$ à partir duquel se produit cette variation de pression étant détecté, l'attaque est poursuivie pendant la durée $t_3$ à $t_4$ pour assurer, d'une part, que la couche mince à éliminer l'est complètement même dans les endroits où la gravure aurait été moins rapide, d'autre part que la surgravure latérale sous le masque est de dimension constante.

L'augmentation de la précision sur la valeur de la surgravure obtenue par la présente invention se comprend aisément. En effet, dans l'art antérieur, en l'absence de dispositif de détection, on évaluait grossièrement la durée entre les instants $t_2$ et $t_4$ et l'on tentait de la rendre constante d'une gravure à l'autre, alors même que les conditions pouvaient varier lors de l'attaque sous plasma. Par contre, selon la présente invention, on mesure l'instant $t_3$ et l'on rend constante la durée entre les instants $t_3$ et $t_4$. On s'affranchit donc des variations aléatoires qui peuvent se produire sur la durée d'attaque entre les instants $t_2$ et $t_3$.

A titre d'ordre de grandeur, on pourra noter que dans certains cas pratiques, pour une couche de silicium polycristallin d'une épaisseur de l'ordre du micron, la durée d'attaque peut être de l'ordre de quelques minutes, par exemple 2 à 3 min, alors que la durée de prolongation d'attaque entre les instants $t_3$ et $t_4$ sera de l'ordre de quelques dizaines de secondes, par exemple 10 à 30 s.

Les dispositifs classiques de mesure et de détection des variations de pression pourront facilement être utilisés par l'homme de l'art pour la mise en œuvre de la présente invention. On utilisera par exemple, à la sortie d'un capteur de pression disposé dans l'enceinte, un détecteur de pression instantanée et un détecteur de pression moyenne sur une relativement courte durée. La pression instantanée sera comparée à la pression moyenne. On pourra ainsi détecter la présence du palier de pression avant l'instant $t_3$, puis cet instant $t_3$ par la détermination de l'écart entre la valeur moyenne et la valeur instantanée. Bien entendu, d'autres procédés classiques de mesure et de détection de variation de pression pourront être utilisés.

La présente invention n'est pas limitée aux modes de réalisation et aux applications spécifiques qui ont été décrites précédemment. Elle en englobe au contraire les variantes et généralisations incluses dans le domaine des revendications ci-après.

## Revendications

1. Procédé d'attaque complète sous plasma d'une couche mince déposée sur un substrat de nature physique ou chimique distincte, caractérisé en ce qu'il comprend les étapes suivantes:
— mesurer la pression dans l'enceinte dans laquelle se produit l'attaque, et
— arrêter l'attaque après que la pression a atteint un palier, puis s'écarte de la valeur correspondant à ce palier.

2. Dispositif d'attaque complète sous plasma d'une couche mince déposée sur un substrat de nature physique ou chimique distincte, caractérisé en ce qu'il comprend:
— des moyens de mesure de la pression dans l'enceinte dans laquelle se produit l'attaque;
— des moyens de détection des variations de cette pression, et
— des moyens pour fournir un signal de commande propre à provoquer l'arrêt de l'opération d'attaque une fois que la pression a atteint un palier et peu après qu'elle s'est écartée de ce palier.

3. Dispositif selon la revendication 2, caractérisé en ce que les moyens de détection des variations de pression comprennent un détecteur de valeur moyenne de la pression et un détecteur de valeur instantanée de la pression, les sorties de ces détecteurs étant fournies à un comparateur.

## Claims

1. Method of complete plasma-etching of a thin layer deposited on a substrate of different physical or chemical nature, characterized in that it comprises the following steps:

— measuring the pressure within the chamber where said etching is produced, and

— stopping said etching after the pressure has reached a step and subsequently departs from the value corresponding to this step.

2. Device for the complete plasma-etching of a thin layer deposited on a substrate of different physical or chemical nature, characterized in that it comprises:

— means for measuring the pressure within the chamber where said etching is produced;

— means for detecting variations of this pressure, and

— means for providing a control signal adapted to cause the etching operation to be stopped as soon as the pressure has reached a step and shortly after it has departed from this step.

3. Device according to claim 2, characterized in that the means for detecting the pressure variations comprise a detector for detecting the average value of the pressure and a detector for detecting the momentary value of the pressure, the outputs of these detectors being supplied to a comparator.

**Patentansprüche**

1. Verfahren zur vollständigen, unter einem Plasma erfolgenden Abätzung einer auf einem Substrat anderer physikalischer oder chemischer Art abgelagerten Dünnschicht, dadurch gekennzeichnet, dass es folgende Schritte umfasst:

— Messung des Druckes in der Kammer, in welcher die Ätzung erfolgt, und

— Beendigung der Ätzung, nachdem der Druck eine Stufe erreicht hat und anschliessend von dem dieser Stufe entsprechenden Wert abweicht.

2. Vorrichtung zur vollständigen und unter einem Plasma erfolgenden Abätzung einer Dünnschicht, die auf einem Substrat anderer chemischer oder physikalischer Art abgelagert ist, dadurch gekennzeichnet, dass sie umfasst:

— Mittel zur Messung des Druckes in der Kammer, in welcher der Ätzvorgang erfolgt,

— Mitteil zur Erfassung der Änderungen dieses Druckes, und

— Mittel zum Abgeben eines Steuersignals, das geeignet ist, die Beendigung des Ätzvorganges hervorzurufen, sobald der Druck eine Stufe erreicht hat und kurzzeitig nachdem er sich von dieser Stufe entfernt.

3. Vorrichtung nach Anspruch 2, dadurch gekennzeichnet, dass die Mittel zur Erfassung der Druckänderungen einen Druckmittelwert-Detektor und einen Augenblickswert-Druckdetektor umfassen, wobei die Ausgänge dieser Detektoren an einen Komparator angelegt sind.

# Fig. 1

# Fig. 2